# EUROPEAN PATENT SPECIFICATION

(11) **EP 3 978 888 B1**
(45) Date of publication and mention of the grant of the patent: **29.01.2025**
(21) Application number: 21210330.3
(22) Date of filing: 24.11.2021
(51) Int. Cl.: G01L 19/00, G01L 19/14

(54) **PRESSURE SENSOR MODULE APPARATUS AND METHOD OF MANUFACTURING THE SAME**
DRUCKSENSORMODULVORRICHTUNG UND VERFAHREN ZUR HERSTELLUNG DAVON
APPAREIL DE MODULE DE CAPTEUR DE PRESSION ET SON PROCÉDÉ DE FABRICATION

(43) Date of publication of application: 06.04.2022
(73) Proprietor: Melexis Technologies NV, 3980 Tessenderlo (BE)
(72) Inventor: CLAESEN, Karel, 3980 Tessenderlo (BE); OTTE, Laurent, 3980 Tessenderlo (BE)
(74) Representative: Kay, Ross Marcel

(56) References cited:
- CA-A1- 2 245 817
- JP-A- 2015 222 175
- US-A1- 2006 000 265
- US-A1- 2006 086 188

## Description

The present invention relates to pressure sensor module apparatus of the type that, for example, comprises a pressure sensor device coupled to a module pressure sensor port and operably coupled to an electronic circuit. The present invention also relates to a method of manufacturing a pressure sensor module apparatus, the method being of the type that, for example, comprises coupling a pressure sensor device to a module pressure sensor port and electrically connecting the pressure sensor device to an electronic circuit.

In the field of pressure sensors, it is known to provide a packaged pressure sensor device. The pressure sensor device typically comprises a pressure sensitive element and a lead frame contained within an overmoulded device package. The device package comprises an interfacing region carrying an access aperture on the underside of the device package providing fluid communication access to the pressure sensitive element and for coupling the pressure sensor device to a pressure port of a pressure sensing module into which the pressure sensor device is to be installed.

Typically, the pressure sensor module comprises an electrical circuit to which the pressure sensor device is surface-mount soldered. As well as soldering the pressure sensor device to the electronic circuit, it is necessary to sealingly connect the access aperture of the pressure sensor device to the pressure port of the pressure sensor module. In a mass-production environment requiring cost-effectiveness, it is challenging to solder the leads of the pressure sensor device to the electronic circuit of the pressure sensor module while also hermetically sealing the connection between the access aperture and the pressure port.

US patent publication 2020/378282 exemplifies such an arrangement where a surface-mount pressure sensor device is soldered to a circuit carrier integrated with a pressure sensor module and to which the sensor device is also adhered. The construction disclosed in US patent publication 2020/378282 is complex, rendering it difficult to manufacture and to ensure reliable manufacture quality without incurring excessive expense. In this regard, the thermal steps of the manufacturing process require a combination of adhesive curing to form the hermetic seal and reflow soldering. Additionally, it is necessary to apply the adhesive for curing and solder paste to the circuit carrier, and applying both the adhesive and the solder paste together is practically challenging from a manufacturing perspective. Furthermore, the circuit carrier has to be suitable for exposure to a medium being measured and this too results in constraints being placed on the choice of material employed for the circuit carrier, which increases the cost of manufacture of the pressure sensor module. JP 2015/222175 A disclosed an electronic control unit comprising a packaged pressure sensor disposed therein. US 2006/000265 A1 discloses a system comprising an unpackaged sense die disposed within a housing.

According to a first aspect of the present invention, there is provided a pressure sensor module apparatus in accordance with claim 1.

The intermediate carrier may be fixedly coupled to the module portion (100).

A portion of the upstanding pressure port may extend through the access aperture of the intermediate carrier.

The module portion may comprise a base, and the upstanding pressure port may be elongate and extend away from the base and through the intermediate carrier.

The upstanding pressure port may be adhered to the opposing surface of the moulded device package surrounding the access port of the pressure sensor device.

The module portion and the intermediate carrier may be configured to cooperate so that the module portion receives the intermediate carrier therein and in a predetermined position within the module portion.

The intermediate carrier may comprise a first locator aperture and a second locator aperture.

The intermediate carrier may comprise a third locator aperture. The module portion may comprise a first counterpart locator protrusion and a second counterpart locator protrusion, respectively configured to be received by the first and second locator apertures. The module portion may comprise a third counterpart locator protrusion configured to be received by the third locator aperture.

The module portion may comprise a base portion and the upstanding pressure port may be configured as an island in the base portion.

The module portion may comprise a base portion and the upstanding pressure port may have an abutting surface distal from the base portion; the upstanding pressure port may be configured to carry a peripheral lip at the distal end thereof.

The upstanding pressure port may comprise a central conduit defined by a tubular wall; the peripheral lip may be disposed at an internal edge of the tubular wall.

The upstanding pressure port may comprise a central conduit defined by a tubular wall; the peripheral lip may be disposed at an external edge of the tubular wall.

The upstanding pressure port may comprise a central conduit defined by a tubular wall; the peripheral lip may be disposed at an internal edge of the tubular wall and another peripheral lip may be disposed at an external edge of the tubular wall, thereby defining a recessed channel in the abutting surface.

The module portion may comprise a base portion and the upstanding pressure port may have an abutting surface distal from the base portion; and the abutting surface may be configured to provide augmented wettability as compared with the abutting surface being untreated.

According to a second aspect of the present invention, there is provided a pressure sensing module comprising: the pressure sensor module apparatus as set for the above in relation to the first aspect of the invention; and a pressure sensor module housing comprising the module portion.

The module portion may comprise a tubular protrusion defining the upstanding pressure port; the tubular protrusion may extend towards the access port; the tubular protrusion may comprise an abutting surface at a distal end of the tubular protrusion; and a layer of bonding compound may be disposed between the abutting surface and the moulded device package.

The tubular protrusion may extend towards the access port through the access aperture of the intermediate carrier.

According to a third aspect of the present invention, there is provided a method of manufacturing a pressure sensor module apparatus in accordance with claim 15.

It is thus possible to provide an apparatus and method that facilitates simpler manufacture of the apparatus. In this regard, the application of adhesive and solder paste does not have to be done so as to accommodate contemporaneous curing of adhesive and reflow soldering. Additionally, the production yield is improved owing to a lesser degree of accuracy being required since the adhesive and solder paste deposition steps are decoupled.

At least one embodiment of the invention will now be described, by way of example only, with reference to the accompanying drawings, in which:
**Figure 1** is a schematic diagram of a pressure sensor device coupled to an interfacing substrate of a pressure sensor module constituting an embodiment of the invention;
**Figures 2** is an end elevation of a pressure sensor device to be interfaced with a pressure port of the pressure sensor module of Figure 1 and to form part of the pressure sensor module;
**Figure 3** is a underside view of an interfacing side of the pressure sensor device of Figure 2;
**Figure 4** is a flow diagram of a method of manufacturing a pressure sensor module constituting another embodiment of the invention;
**Figure 5** is schematic plan view of an intermediate carrier for attachment to the interfacing substrate of the pressure sensor module;
**Figure 6** is a cross-sectional view of the intermediate carrier of Figure 5 along line A-A prior to coupling of the pressure sensor device of Figure 1 thereto;
**Figure 7** is a cross-sectional view of the carrier of Figure 5 along line A-A following application of solder paste thereto;
**Figure 8** is a cross-sectional view of the carrier of Figure 5 along line A-A following soldering of the pressure sensor device thereto;
**Figure 9** is a schematic plan view of the interfacing substrate of the pressure sensor module prior to coupling of the intermediate carrier with pressure sensor device thereto;
**Figure 10** is a cross-sectional view of the interfacing substrate of the pressure sensor module of Figure 9 along line B-B;
**Figure 11** is a cross-sectional view of the interfacing substrate of the pressure sensor module of Figure 9 along line C-C;
**Figure 12** is a cross-sectional view of the pressure sensor device attached to the intermediate carrier, and the interfacing substrate of the pressure sensor module prior to attachment of the intermediate carrier with the pressure sensor device thereto;
**Figure 13** is a plan view of the intermediate carrier carrying the pressure sensor device attached to the interfacing substrate of the pressure sensor module;
**Figure 14** is a cross-sectional view of the interfacing substrate of the pressure sensor module of Figure 9 along the line C-C in another embodiment of the invention;
**Figure 15** is a cross-sectional view of the interfacing substrate of the pressure sensor module of Figure 9 along the line C-C in yet another embodiment of the invention; and
**Figure 16** is a cross-sectional view of the interfacing substrate of the pressure sensor module of Figure 9 along the line C-C in a further embodiment of the invention.

Throughout the following description, identical reference numerals will be used to identify like parts.

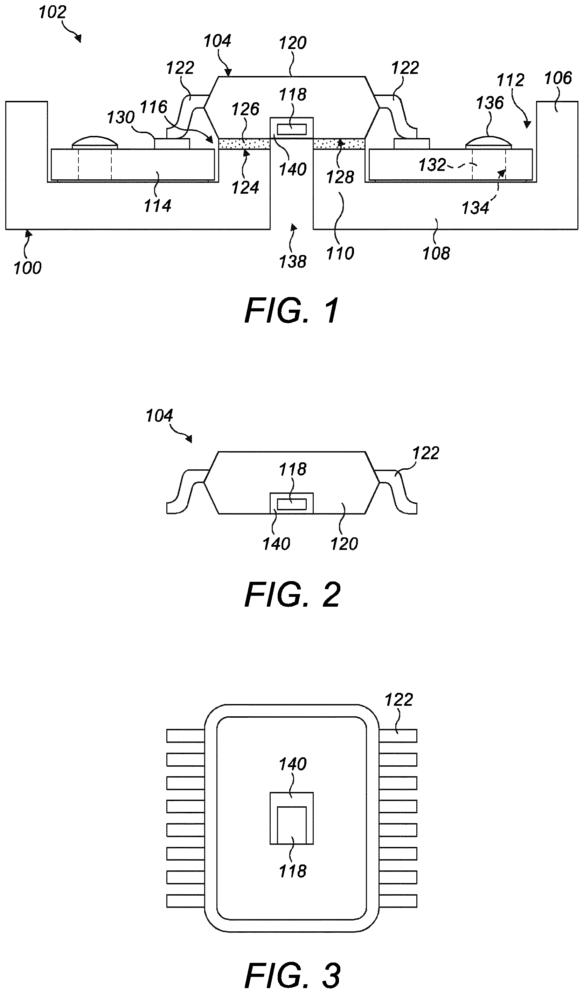

Referring to Figures 1 to 3, a portion 100 of a pressure sensor module 102, constituting an interfacing substrate 100, is operably coupled to a pressure sensor device 104. The pressure sensor device 104 forms part of the pressure sensor module 102. The interfacing substrate 100 comprises a peripheral side wall 106 integrally formed with a base portion 108 and a port formation 110, for example an upstanding pressure port, extending away from the base portion 108. In this example, the port formation 110 is generally centrally located relative to the peripheral side wall 106. The peripheral side wall 106, the base portion 108 and the port formation 110 cooperate to provide a recess 112 for receiving an intermediate carrier 114 comprising an access aperture 116 therethrough so that the intermediate carrier 114 is adjacent the interfacing substrate 100, in particular the base portion 108. As such, the port formation 110 extends away from the base portion 108 and through the access aperture 116 of the intermediate carrier 114.

As described above, the pressure sensor module 102 is only described in part, and the skilled person should appreciate that the interfacing substrate 100 is described in isolation for the sake of clarity and conciseness description. In this regard, the pressure sensor module 102 can comprise a housing of any shape suited to an intended application, the housing comprising the interfacing substrate 100.

The pressure sensor device 102 comprises a pressure sensitive element 118, for example of the type disclosed in European patent publication no. EP-A1-3 617 686, disposed within a moulded device package 120. Although not shown, connecting leads 122 extend through the moulded device package 120 to protrude therefrom at one end thereof and, at another end thereof, are coupled to the pressure sensitive element 118, optionally via an integrated circuit (not shown) disposed within the moulded device package 120.

The port formation 110 of the interfacing substrate 100 comprises an outwardly facing surface 124 at a distal end thereof, serving as an adhesion site and/or an abutting surface. The outwardly facing surface 124 in combination with the port formation 110 also constitutes an adhesion island within the base portion 108.

The intermediate carrier 114 comprises electrical contact pads (not shown in Figures 1 to 3) disposed along opposite sides of the aperture 116 close to the aperture 116 and spaced so as to be in registry with a spacing between the connecting leads 122 of the pressure sensor device 104. The connecting leads 122 of the pressure sensor device 104 are connected to the corresponding electrical contact pads of the intermediate carrier 114 by respective solder joints 130.

The intermediate carrier 114 serves as, for example, a circuit board comprising one or more electrical circuit interconnects, and can comprise an electrical circuit (not shown) operably coupled to the electrical contact pads; the one or more electrical circuit interconnects can comprise the electrical contact pads, respectively. In this example, the intermediate carrier 114 is a Printed Circuit Board (PCB). In some examples, the intermediate carrier 114 comprise one or more circuit component coupled thereto. The intermediate carrier 114 is retained within the recess 112 in a predetermined position by locator protrusions 132 extending away from the base portion 108, which pass through corresponding locator apertures 134 provided in the intermediate carrier 114. The intermediate carrier 114 is fixed in place by rivet heads 136 formed on the tops of the locator protrusions 132, thereby preventing removal of the intermediate carrier 114 from the locator protrusions 132.

The port formation 110 comprises a substantially tubular wall and provides a conduit 138, for example a central conduit, therethrough which is in fluid communication at a first end thereof with a chamber 140 defined by the moulded device package 120, the pressure sensitive element 118 being located within the chamber 140. An opening to the chamber 140 serves as an access port. A second end of the conduit 138 is in fluid communication with at least part of the remainder of the pressure sensor module 102 (not shown). An adhesive layer 126 disposed on the outwardly facing surface 124 contacts an opposing surface 128 of the moulded device package 120, peripheral to the opening of the chamber 140 and serving as an interfacing surface, and sealingly coupled, for example by adhesion, the moulded device package 120 to the port formation 110.

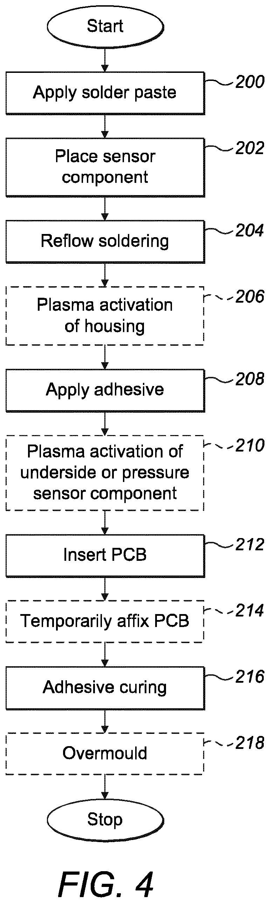

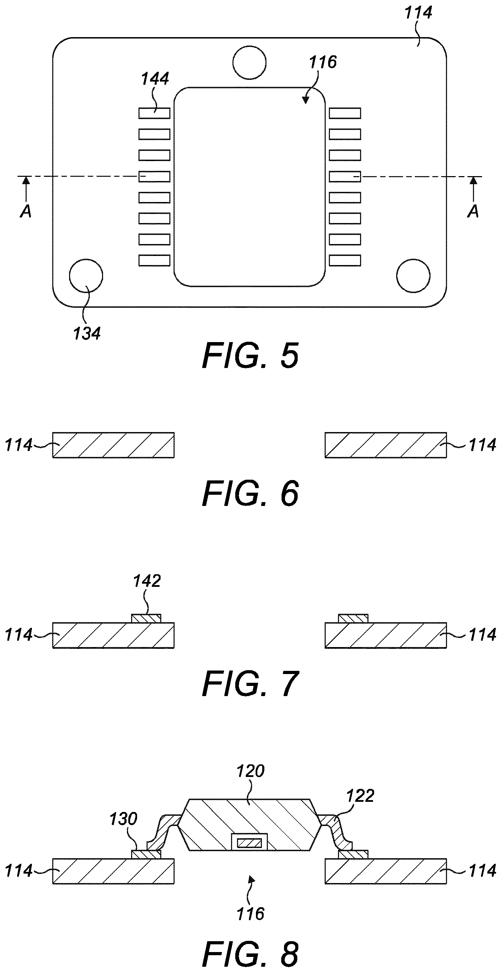

Turning to Figure 4, and also referring to Figures 5, 6 and 7, solder paste 142 is applied (Step 200) to the electrical contact pads 144 of the intermediate carrier 114 and the pressure sensor device 104 is arranged (Step 202) on the intermediate carrier 114, which is in an unpopulated state, so that free ends of the connecting leads 122 contact the solder paste 142. Following placement of the pressure sensor device 104 on the intermediate carrier 114, the intermediate carrier 114 and the pressure sensor device 104 undergo a solder reflow process (Step 204) so that the connecting leads of the pressure sensor device 104 are reflow soldered to the electrical contact pads 144 of the intermediate carrier 114, resulting in the formation of the solder joints 130 (Figure 8).

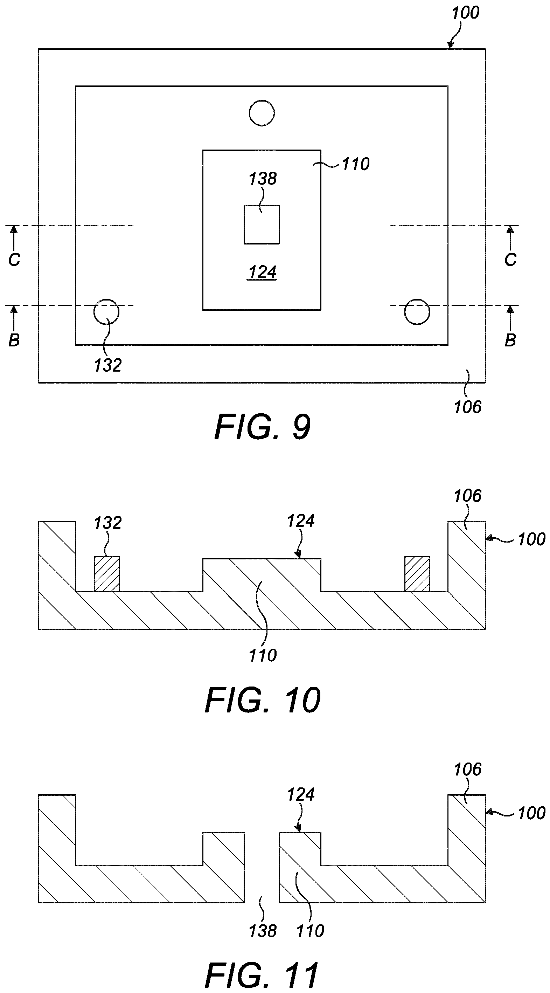

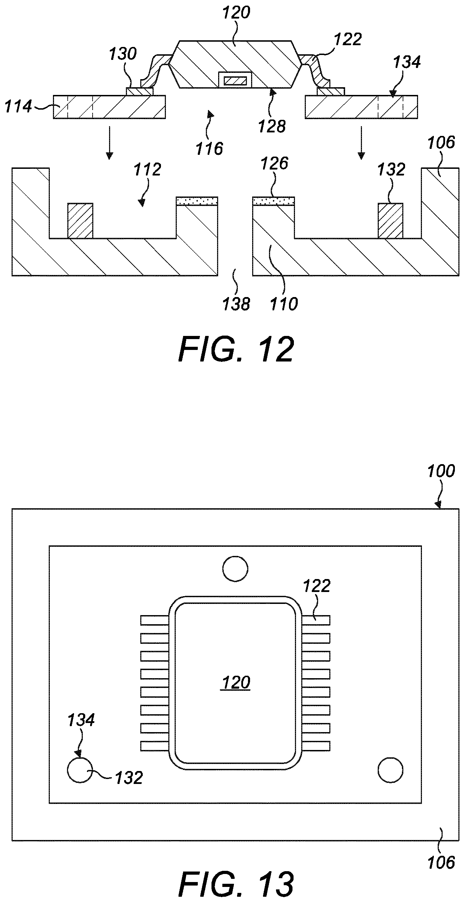

Referring to Figures 9, 10 and 11, the interfacing substrate 100 is then optionally subjected (Step 206) to plasma activation using any suitable known process, particularly but not exclusively to improve wettability of the outwardly facing surface 124 as compared with the outwardly facing surface 124 being untreated. Turning to Figure 12, the adhesive layer 126 is then applied (Step 208) to the outwardly facing surface 124 of the interfacing substrate 100 and then the interfacing surface 128 of the moulded device package 120 is optionally also subjected (Step 210) to plasma activation using any suitable known process, to improve wettability of the interfacing surface 128 as compared with the interfacing surface being untreated. In this example, the adhesive layer 126 is a heat curable adhesive, although the skilled person should appreciate that any other suitable kind of adhesive can be employed, for example an adhesive pre-cured by ultraviolet light prior to contact adhesion.

The intermediate carrier 114 is then inserted (Step 212) into the recess 112 of the interfacing substrate 100, the locator apertures 134 being aligned with the locator protrusions 132 so that the locator protrusions 132 extend through the locator apertures 134 when the intermediate carrier 134 is inserted into the recess 112 (Figure 13), thereby aligning the open end of the chamber 140 with the conduit 138 (Figure 1). In this state, the intermediate carrier 114 is temporarily aligned in the recess 112. The rivet heads 136 are then formed at the exposed ends of the locator protrusions 132 to affix (Step 214) the intermediate carrier 114 temporarily in the recess 112. Thereafter, the adhesive layer 126 is cured (Step 216) using any suitable known curing process and then the interfacing substrate 100, with the intermediate carrier 114 and the pressure sensor device 204 are optionally overmoulded (Step 218).

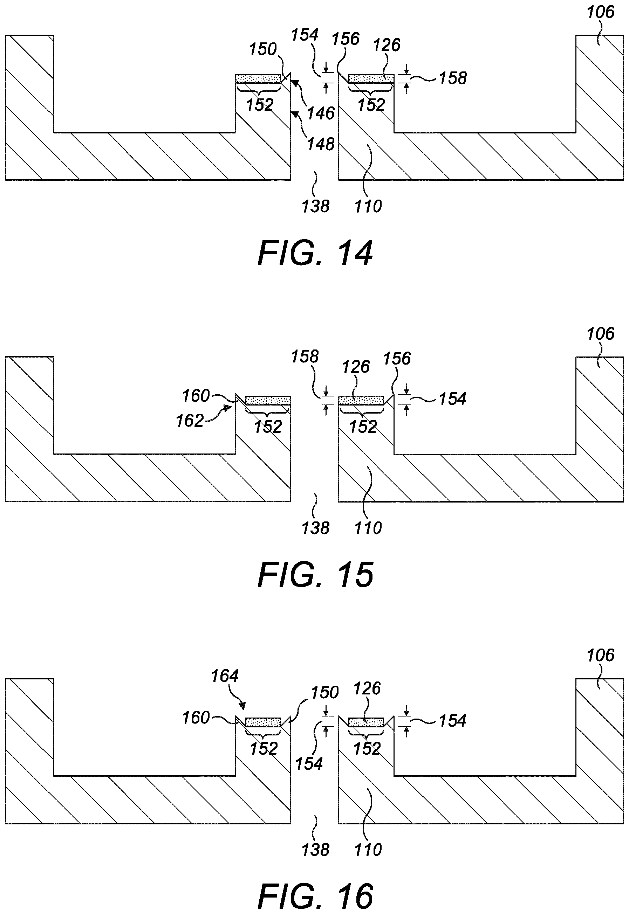

The skilled person should appreciate that the above-described implementations are merely examples of the various implementations that are conceivable within the scope of the appended claims. Indeed, it should be appreciated that although, in the above-described example, the outwardly facing, interfacing, surface 124 of the port formation 110 is flat, in other examples the outwardly facing surface 124 of the port formation 110 can comprise one or more peripheral boundary formations, for example peripheral lips. Referring to Figure 14, in one example an inner edge 146 of the outwardly facing surface 124 relative to the internal surface 148 of the port formation 110 comprises a first inner peripheral lip 150. In this example, the first inner peripheral lip 150 slopes towards the base portion 108 so that the outwardly facing surface 124 comprises a flat or level surface portion 152 that meets the first inner peripheral lip 150. A perpendicular height 154 of a highest point 156 of the first peripheral lip 150 with respect to the flat portion 152 of the outwardly facing surface 124 is equal to, or slightly greater than, an intended thickness 158 of the adhesive layer 126. In another example (Figure 15), the outwardly facing surface 124 can comprise a second, outer, peripheral lip 160 at an outer edge 162 of the port formation 110, the second peripheral lip 160 being provided instead of the first peripheral lip 150. The highest point of the second peripheral lip 160 is at the outer edge 162 of the port formation 110, and the second peripheral lip 160 slopes in a like manner to the first peripheral lip 150 described above. Similarly, the perpendicular height 154 of the second peripheral lip 160 with respect to the flat surface portion 152 of the outwardly facing surface 124 is defined in the same way as the first peripheral lip 150. In a further example (Figure 16), the outer peripheral surface 124 can comprise both the first and second peripheral lips 150, 160, thereby forming a recessed channel 164 in the outwardly facing surface 124.

In the above examples, the interfacing substrate 100 carries locator pins 132 and the intermediate carrier 114 comprises corresponding locator apertures 134. However, the skilled person should appreciate that any suitable means of locating the intermediate carrier 114 within the recess 112 of the interfacing substrate 100 can be employed. Indeed, the interfacing substrate 100 can comprise a first formation or plurality of formations and the intermediate carrier 114 can comprise a second, counterpart, formation or plurality of formations, to achieve alignment of the intermediate carrier within the recess 112 of the interfacing substrate 100.

## Claims

1. A pressure sensor module apparatus (102) comprising:
a pressure sensor device (104) comprising:
a pressure sensitive element (118) contained within a moulded device package (120);
connecting leads (122) operably coupled to the pressure sensitive element (118) and protruding through the moulded device package (120) for electrical connection thereto; and
an access port formed in the moulded device package (120) and configured to provide fluid communication with the pressure sensitive element (118);
an intermediate carrier (114) comprising an electrical circuit interconnect and an access aperture (116) therethrough, the intermediate carrier (114) comprising electrical contacts (144);
a module portion (100), the intermediate carrier (114) being disposed adjacent the module portion (100); and
the connecting leads (122) are respectively soldered to the electrical contacts (144) of the electrical circuit interconnect; the apparatus further comprising:
the access aperture (116) facing the access port formed in the moulded device package (120);
the module portion (100) comprising an upstanding pressure port (110);
the upstanding pressure port (110) being sealingly coupled to an opposing surface (128) of the moulded device package (120) surrounding the access port of the pressure sensor device (104); and
the upstanding pressure port (110) extending through the access aperture (116) of the intermediate carrier (114).

2. An apparatus as claimed in Claim 1, wherein the intermediate carrier (114) is fixedly coupled to the module portion (100).

3. An apparatus as claimed in Claim 1 or Claim 2, wherein a portion of the upstanding pressure port (110) extends through the access aperture (116) of the intermediate carrier (114).

4. An apparatus as claimed in any one of the preceding claims, wherein the upstanding pressure port (110) is adhered to the opposing surface (128) of the moulded device package (120) surrounding the access port of the pressure sensor device (104).

5. An apparatus as claimed in any one of the preceding claims, wherein the module portion (100) and the intermediate carrier (114) are configured to cooperate so that the module portion (100) receives the intermediate carrier (114) therein and in a predetermined position within the module portion (100).

6. An apparatus as claimed in any one of the preceding claims, wherein the intermediate carrier (114) comprises a first locator aperture (134) and a second locator aperture (134).

7. An apparatus as claimed in any one of the preceding claims, wherein the module portion (100) comprises a base portion (108) and the upstanding pressure port (110) is configured as an island in the base portion (108).

8. An apparatus as claimed in any one of Claims 1 to 6, wherein the module portion (100) comprises a base portion (108) and the upstanding pressure port (110) has an abutting surface distal from the base portion (108), the upstanding pressure port (110) being configured to carry a peripheral lip (150, 160) at the distal end thereof.

9. An apparatus as claimed in Claim 8, wherein the upstanding pressure port (110) comprises a central conduit (138) defined by a tubular wall, the peripheral lip (150) being disposed at an internal edge (146) of the tubular wall.

10. An apparatus as claimed in Claim 8, wherein the upstanding pressure port (110) comprises a central conduit (138) defined by a tubular wall, the peripheral lip (160) being disposed at an external edge (162) of the tubular wall.

11. An apparatus as claimed in Claim 8, wherein the upstanding pressure port (110) comprises a central conduit (138) defined by a tubular wall, the peripheral lip (150) being disposed at an internal edge (146) of the tubular wall and another peripheral lip (160) being disposed at an external edge (162) of the tubular wall, thereby defining a recessed channel (164) in the abutting surface (124).

12. An apparatus as claimed in any one of Claims 1 to 7, wherein the module portion (100) comprises a base portion (108) and the upstanding pressure port (110) has an abutting surface (124) distal from the base portion (108); and the abutting surface (124) is configured to provide augmented wettability as compared with the abutting surface (124) being untreated.

13. A pressure sensing module comprising:
the pressure sensor module apparatus (102) as claimed in any one of the preceding claims; and
a pressure sensor module housing comprising the module portion (100).

14. An apparatus as claimed in any one of Claims 1 to 7, wherein
the module portion (100) comprises a tubular protrusion defining the upstanding pressure port (110);
the tubular protrusion extends towards the access port;
the tubular protrusion comprises an abutting surface (124) at a distal end of the tubular protrusion; and
a layer of bonding compound (126) is disposed between the abutting surface (124) and the moulded device package (120).
The tubular protrusion may extend towards the access port through the access aperture of the intermediate carrier.

15. A method of manufacturing a pressure sensor module apparatus (102), the method comprising:
providing a pressure sensor device (104) comprising:
a pressure sensitive element (118) contained within a moulded device package (120);
connecting leads (122) operably coupled to the pressure sensitive element (118) and protruding through the moulded device package (120) for electrical connection thereto; and
an access port formed in the moulded device package (120) and configured to provide fluid communication with the pressure sensitive element (118);
providing an intermediate carrier (114) comprising an electrical circuit interconnect and an access aperture (116) therethrough, the electrical circuit interconnect comprising electrical contacts (144);
providing a module portion (100);
soldering (200, 204) the connecting leads (122) respectively to the electrical contacts (144) of the electrical circuit interconnect; and
disposing (212) the intermediate carrier (114) adjacent the module portion (100); the method further comprising:
locating the access aperture (116) to face the access port formed in the moulded device package (120);
providing the module portion (100) with an upstanding pressure port (110);
sealingly coupling (216) the upstanding pressure port (110) to an opposing surface (128) of the moulded device package (120) surrounding the access port of the pressure sensor device (104); and
the upstanding pressure port (110) extending through the access aperture (116) of the intermediate carrier (114).

## Patentansprüche

1. Eine Drucksensormodulapparatur (102), umfassend:
eine Drucksensorvorrichtung (104) umfassend:
ein druckempfindliches Element (118), das in einem geformten Vorrichtungspaket (120) enthalten ist;
Verbindungsleitungen (122), die funktionsfähig mit dem druckempfindlichen Element (118) gekoppelt sind und durch das geformte Vorrichtungspaket (120) für eine elektrische Verbindung mit diesem vorstehen; und
ein Zugangsanschluss, der in dem geformten Vorrichtungspaket (120) ausgebildet und dazu konfiguriert ist, eine Fluidverbindung mit dem druckempfindlichen Element (118) herzustellen;
einen Zwischenträger (114), der eine elektrische Verbindungsschaltung und eine Zugangsöffnung (116) durch ihn hindurch umfasst, wobei der Zwischenträger (114) elektrische Kontakte (144) umfasst;
einen Modulteil (100), wobei der Zwischenträger (114) angrenzend an den Modulteil (100) angeordnet ist; und
die Verbindungsleitungen (122) jeweils mit den elektrischen Kontakten (144) der elektrischen Verbindungsschaltung verlötet sind; wobei die Apparatur ferner umfasst:
die Zugangsöffnung (116), die dem im geformten Vorrichtungspaket (120) ausgebildeten Zugangsanschluss gegenüberliegt;
den Modulteil (100), der einen aufrechtstehenden Druckanschluss (110) umfasst;
wobei der aufrechtstehende Druckanschluss (110) abdichtend mit einer gegenüberliegenden Oberfläche (128) des geformten Vorrichtungspakets (120) gekoppelt ist, die den Zugangsanschluss der Drucksensorvorrichtung (104) umgibt; und
wobei sich der aufrechtstehende Druckanschluss (110) durch die Zugangsöffnung (116) des Zwischenträgers (114) erstreckt.

2. Apparatur nach Anspruch 1, wobei der Zwischenträger (114) fest mit dem Modulteil (100) gekoppelt ist.

3. Apparatur nach Anspruch 1 oder 2, wobei sich ein Teil des aufrechtstehenden Druckanschlusses (110) durch die Zugangsöffnung (116) des Zwischenträgers (114) erstreckt.

4. Apparatur nach einem der vorhergehenden Ansprüche, wobei der aufrechtstehende Druckanschluss (110) an der gegenüberliegenden Oberfläche (128) des geformten Vorrichtungspakets (120), die den Zugangsanschluss der Drucksensorvorrichtung (104) umgibt, angeklebt ist.

5. Apparatur nach einem der vorhergehenden Ansprüche, wobei der Modulteil (100) und der Zwischenträger (114) so konfiguriert sind, dass sie zusammenwirken, so dass der Modulteil (100) den Zwischenträger (114) darin und in einer vorbestimmten Position innerhalb des Modulteils (100) aufnimmt.

6. Apparatur nach einem der vorangehenden Ansprüche, wobei der Zwischenträger (114) eine erste Positionieröffnung (134) und eine zweite Positionieröffnung (134) aufweist.

7. Apparatur nach einem der vorhergehenden Ansprüche, wobei der Modulteil (100) einen Basisteil (108) umfasst und der aufrechtstehende Druckanschluss (110) als Insel im Basisteil (108) konfiguriert ist.

8. Apparatur nach einem der Ansprüche 1 bis 6, wobei der Modulteil (100) einen Basisteil (108) umfasst und der aufrechtstehende Druckanschluss (110) eine vom Basisteil (108) distal gelegene Stoßfläche aufweist, wobei der aufrechtstehende Druckanschluss (110) so konfiguriert ist, dass er an seinem distalen Ende eine Umfangslippe (150, 160) trägt.

9. Apparatur nach Anspruch 8, wobei der aufrechtstehende Druckanschluss (110) eine zentrale Leitung (138) umfasst, die durch eine rohrförmige Wand definiert ist, wobei die Umfangslippe (150) an einer Innenkante (146) der rohrförmigen Wand angeordnet ist.

10. Apparatur nach Anspruch 8, wobei der aufrechtstehende Druckanschluss (110) eine zentrale Leitung (138) umfasst, die durch eine rohrförmige Wand definiert ist, wobei die Umfangslippe (160) an einem Außenrand (162) der rohrförmigen Wand angeordnet ist.

11. Apparatur nach Anspruch 8, wobei der aufrechtstehende Druckanschluss (110) eine zentrale Leitung (138) umfasst, die durch eine rohrförmige Wand definiert ist, wobei die Umfangslippe (150) an einer Innenkante (146) der rohrförmigen Wand angeordnet ist und eine weitere Umfangslippe (160) an einer Außenkante (162) der rohrförmigen Wand angeordnet ist, wodurch ein vertiefter Kanal (164) in der Stoßfläche (124) definiert wird.

12. Apparatur nach einem der Ansprüche 1 bis 7, wobei der Modulteil (100) einen Basisteil (108) umfasst und der aufrechtstehende Druckanschluss (110) eine vom Basisteil (108) entfernte Stoßfläche (124) aufweist; und die Stoßfläche (124) so konfiguriert ist, dass sie im Vergleich zur unbehandelten Stoßfläche (124) eine erhöhte Benetzbarkeit bietet.

13. Ein Drucksensormodul, umfassend:
die Drucksensormodulapparatur (102) nach einem der vorangehenden Ansprüche; und
ein Drucksensormodulgehäuse, das den Modulteil (100) umfasst.

14. Apparatur nach einem der Ansprüche 1 bis 7, wobei
der Modulteil (100) einen rohrförmigen Vorsprung aufweist, der den aufrechtstehenden Druckanschluss (110) definiert;
der rohrförmige Vorsprung sich in Richtung des Zugangsanschlusses erstreckt;
der rohrförmige Vorsprung eine Stoßfläche (124) an einem distalen Ende des rohrförmigen Vorsprungs aufweist; und
eine Schicht aus einer Bindemischung (126) ist zwischen der Stoßfläche (124) und dem geformten Vorrichtungspaket (120) angeordnet.
Der rohrförmige Vorsprung kann sich in Richtung der Zugangsöffnung durch den Zugangsanschluss des Zwischenträgers erstrecken.

15. Verfahren zur Herstellung einer Drucksensormodulapparatur (102), wobei das Verfahren umfasst:
Bereitstellen einer Drucksensorvorrichtung (104), umfassend:
ein druckempfindliches Element (118), das in einem geformten Vorrichtungspaket (120) enthalten ist;
Verbindungsleitungen (122), die funktionsfähig mit dem druckempfindlichen Element (118) gekoppelt sind und durch das geformte Vorrichtungspaket (120) für eine elektrische Verbindung mit dieser vorstehen; und
ein Zugangsanschluss, der in dem geformten Vorrichtungspaket (120) ausgebildet und so konfiguriert ist, dass er eine Fluidverbindung mit dem druckempfindlichen Element (118) herstellt;
Bereitstellen eines Zwischenträgers (114), der eine elektrische Verbindungsschaltung und eine Zugangsöffnung (116) durch ihn hindurch umfasst, wobei die elektrische Verbindungsschaltung elektrische Kontakte (144) umfasst;
Bereitstellen eines Modulteils (100);
Löten (200, 204) der Verbindungsleitungen (122) jeweils an die elektrischen Kontakte (144) der elektrischen Verbindungsschaltung; und
Anordnen (212) des Zwischenträgers (114) angrenzend an den Modulteil (100); wobei das Verfahren ferner umfasst:
Anseten der Zugangsöffnung (116) so, dass sie dem im geformten Vorrichtungspaket (120) ausgebildeten Zugangsanschluss gegenüberliegt;
Versehen des Modulteils (100) mit einem aufrechtstehenden Druckanschluss (110);
abdichtendes Kopplen (216) des aufrechtstehenden Druckanschlusses (110) mit einer gegenüberliegenden Oberfläche (128) des geformten Vorrichtungspakets (120), die die Zugangsöffnung der Drucksensorvorrichtung (104) umgibt; wobei sich der aufrechtstehende Druckanschluss (110) durch die Zugangsöffnung (116) des Zwischenträgers (114) erstreckt.

## Revendications

1. Un appareil de module de capteur de pression (102) comprenant :
un dispositif de capteur de pression (104) comprenant :
un élément sensible à la pression (118) contenu dans un boîtier moulé (120) ;
des fils de connexion (122) couplés de manière opérationnelle à l'élément sensible à la pression (118) et dépassant à travers le boîtier moulé (120) pour une connexion électrique à celui-ci ; et un port d'accès formé dans le boîtier moulé (120) et configuré pour fournir une communication fluidique avec l'élément sensible à la pression (118) ;
un support intermédiaire (114) comprenant une interconnexion de circuit électrique et une ouverture d'accès (116) à travers celui-ci, le support intermédiaire (114) comprenant des contacts électriques (144) ;
une partie de module (100), le support intermédiaire (114) étant disposé à côté de la partie de module (100) ; et
les fils de connexion (122) sont respectivement soudés aux contacts électriques (144) de l'interconnexion de circuit électrique ; l'appareil comprenant en outre :
l'ouverture d'accès (116) faisant face au port d'accès formé dans le boîtier moulé (120) ;
la partie de module (100) comprenant un port de pression vertical (110) ; le port de pression vertical (110) étant couplé de manière étanche à une surface opposée (128) du boîtier moulé (120) entourant le port d'accès du dispositif de capteur de pression (104) ; et
le port de pression vertical (110) s'étendant à travers l'ouverture d'accès (116) du support intermédiaire (114).

2. Un appareil selon la revendication 1, dans lequel le support intermédiaire (114) est couplé de manière fixe à la partie de module (100).

3. Un appareil selon la revendication 1 ou 2, dans lequel une partie du port de pression vertical (110) s'étend à travers l'ouverture d'accès (116) du support intermédiaire (114).

4. Un appareil selon l'une quelconque des revendications précédentes, dans lequel le port de pression vertical (110) est adhéré à la surface opposée (128) du boîtier moulé (120) entourant le port d'accès du dispositif de capteur de pression (104).

5. Un appareil selon l'une quelconque des revendications précédentes, dans lequel la partie de module (100) et le support intermédiaire (114) sont configurés pour coopérer de sorte que la partie de module (100) reçoive le support intermédiaire (114) à l'intérieur et dans une position prédéterminée au sein de la partie de module (100).

6. Un appareil selon l'une quelconque des revendications précédentes, dans lequel le support intermédiaire (114) comprend une première ouverture de localisation (134) et une seconde ouverture de localisation (134).

7. Un appareil selon l'une quelconque des revendications précédentes, dans lequel la partie de module (100) comprend une partie de base (108) et le port de pression vertical (110) est configuré comme une île dans la partie de base (108).

8. Un appareil selon l'une quelconque des revendications 1 à 6, dans lequel la partie de module (100) comprend une partie de base (108) et le port de pression vertical (110) a une surface d'appui éloignée de la partie de base (108), le port de pression vertical (110) étant configuré pour porter une lèvre périphérique (150, 160) à son extrémité distale.

9. Un appareil selon la revendication 8, dans lequel le port de pression vertical (110) comprend un conduit central (138) défini par une paroi tubulaire, la lèvre périphérique (150) étant disposée à un bord interne (146) de la paroi tubulaire.

10. Un appareil selon la revendication 8, dans lequel le port de pression vertical (110) comprend un conduit central (138) défini par une paroi tubulaire, la lèvre périphérique (160) étant disposée à un bord externe (162) de la paroi tubulaire.

11. Un appareil selon la revendication 8, dans lequel le port de pression vertical (110) comprend un conduit central (138) défini par une paroi tubulaire, la lèvre périphérique (150) étant disposée à un bord interne (146) de la paroi tubulaire et une autre lèvre périphérique (160) étant disposée à un bord externe (162) de la paroi tubulaire, définissant ainsi un canal en retrait (164) dans la surface d'appui (124).

12. Un appareil selon l'une quelconque des revendications 1 à 7, dans lequel la partie de module (100) comprend une partie de base (108) et le port de pression vertical (110) a une surface d'appui (124) éloignée de la partie de base (108) ; et la surface d'appui (124) est configurée pour fournir une mouillabilité augmentée par rapport à la surface d'appui (124) non traitée.

13. Un module de détection de pression comprenant :
l'appareil de module de capteur de pression (102) selon l'une quelconque des revendications précédentes ; et
un boîtier de module de capteur de pression comprenant la partie de module (100).

14. Un appareil selon l'une quelconque des revendications 1 à 7, dans lequel la partie de module (100) comprend une saillie tubulaire définissant le port de pression vertical (110) ;
la saillie tubulaire s'étend vers le port d'accès ;
la saillie tubulaire comprend une surface d'appui (124) à une extrémité distale de la saillie tubulaire ; et
une couche de composé de liaison (126) est disposée entre la surface d'appui (124) et le boîtier moulé (120).
La saillie tubulaire peut s'étendre vers le port d'accès à travers l'ouverture d'accès du support intermédiaire.

15. Un procédé de fabrication d'un appareil de module de capteur de pression (102), le procédé comprenant :
fournir un dispositif de capteur de pression (104) comprenant :
un élément sensible à la pression (118) contenu dans un boîtier moulé (120) ;
des fils de connexion (122) couplés de manière opérationnelle à l'élément sensible à la pression (118) et dépassant à travers le boîtier moulé (120) pour une connexion électrique à celui-ci ; et un port d'accès formé dans le boîtier moulé (120) et configuré pour fournir une communication fluidique avec l'élément sensible à la pression (118) ;
fournir un support intermédiaire (114) comprenant une interconnexion de circuit électrique et
une ouverture d'accès (116) à travers celui-ci, l'interconnexion de circuit électrique comprenant des contacts électriques (144) ;
fournir une partie de module (100) ;
souder (200, 204) les fils de connexion (122) respectivement aux contacts électriques (144) de l'interconnexion de circuit électrique ; et
disposer (212) le support intermédiaire (114) à côté de la partie de module (100) ; le procédé comprenant en outre :
localiser l'ouverture d'accès (116) pour faire face au port d'accès formé dans le boîtier moulé (120) ;
fournir la partie de module (100) avec un port de pression vertical (110) ; coupler de manière étanche (216) le port de pression vertical (110) à une surface opposée (128) du boîtier moulé (120) entourant le port d'accès du dispositif de capteur de pression (104) ; et
le port de pression vertical (110) s'étendant à travers l'ouverture d'accès (116) du support intermédiaire (114).
